Europäisches Patentamt

European Patent Office

Office européen des brevets

(11) Publication number: **0 506 980 A1**

(12) **EUROPEAN PATENT APPLICATION**
published in accordance with Art. 158(3) EPC

(21) Application number: 91919276.5

(22) Date of filing: 15.10.91

(86) International application number:
PCT/JP91/01397

(87) International publication number:
WO 92/07382 (30.04.92 92/10)

(51) Int. Cl.5: **H01L 27/115**

(30) Priority: 22.10.90 JP 284058/90

(43) Date of publication of application:
07.10.92 Bulletin 92/41

(84) Designated Contracting States:
DE FR GB IT NL

(71) Applicant: SEIKO EPSON CORPORATION
4-1, Nishishinjuku 2-chome
Shinjuku-ku Tokyo 163(JP)

(72) Inventor: KATO, Koji
3-5, Owa 3-chome
Suwa-shi Nagano-ken 392(JP)

(74) Representative: Ouinterno, Giuseppe et al
c/o Jacobacci-Casetta & Perani S.p.A. Via
Alfieri, 17
I-10121 Torino(IT)

(54) STRUCTURE OF SEMICONDUCTOR DEVICE AND MANUFACTURING METHOD THEREOF.

(57) A semiconductor storing device using ferroelectric substances in which, by forming an oxygen-nonpermeable conductive film (107) between a semiconductor substrate (101) and a ferroelectric capacitor, and by making the film (107) nonconductive through an oxidation treatment, oxygen is prevented from diffusing in subsequent heat treatment processes in oxidation atmosphere, and the characteristics of the elements under the oxygen-nonpermeable film can be prevented from deteriorating by oxygen.

Fig. 1(d)

FIELD OF THE INVENTION

The present invention relates to a structure of a memory using a ferroelectric material, particularly to a nonvolatile memory capable of electric re-writing and a process for manufacturing the same.

BACKGROUND OF THE INVENTION

MIS transistors are usually used as a conventional semiconductor nonvolatile memory which make use of a phenomenon that the surface potential of a silicon substrate can be modified through the injection of charge from the silicon substrate into an insulating gate trap or a floating gate, and are practically used as an EPROM (ultra-violet ray erasing type nonvolatile memory) and an EEPROM (electrically rewritable nonvolatile memory). These nonvolatile memories, however, have disadvantages in that an information re-writing voltage is usually as high as about 20 V and that the re-writing time is extremely long (for instance, several tens of msec. in the case of the EEPROM). In addition, the information re-writing number is very small, typically about 100 times, thus posing problems in cases of repeated use,

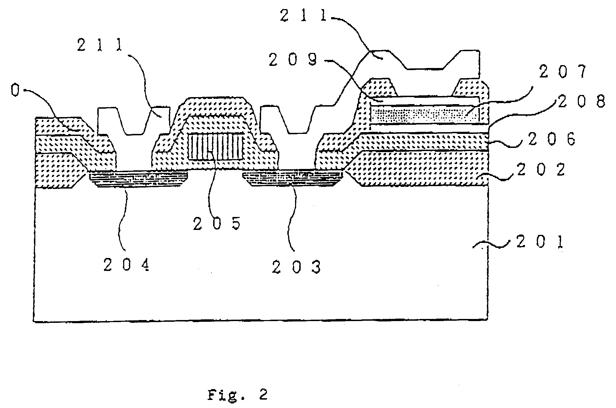

With a nonvolatile memory using a ferroelectric material capable of electrically inverting polarization, the writing-in and reading-out times are substantially the same in principle, and also the polarization is maintained even if the power source is disconnected. Thus, the memory is possibly an ideal nonvolatile memory. As such a nonvolatile memory using a ferroelectric material, there has been proposed a structure in which a ferroelectric capacitor is integrated on a silicon substrate as shown in United States Patent No. 4,149,302, and a nonvolatile memory which has a ferroelectric film provided on a gate portion of a MIS transistor as shown in United States Patent No. 3,832,700. Further, recently a nonvolatile memory having a laminate structure of a MOS semiconductor device as shown in Fig. 2 has been proposed in the IEDM, '87 pp, 850-851.

In Fig. 2, a reference numeral 201 designates a P-type Si substrate, 202 a LOCOS oxide film for isolation, 203 an N-type diffusion layer constituting a source and 204 an N-type diffusion layer constituting a drain. A reference numeral 205 illustrates a gate electrode, and 206 an interlayer insulation film. Designated at a reference numeral 207 is a ferroelectric film, which constitutes a capacitor together with electrodes 208 and 209 having the ferroelectric film therebetween. A reference numeral 210 illustrates a second insulation film and 211 designates Al constituting a lead electrode. Thus, with such a structure wherein the ferroelectric film is stacked on the upper portion of the MOS semiconductor substrate device, there has arisen such a problem that, during the heat or thermal treatment of the structure in an oxygen atmosphere, oxygen diffuses into a semiconductor element to thereby degrade or deteriorate the characteristics or properties of the element.

Then, the present invention seeks to solve this problem, and its object is to provide an excellent semiconductor device by inhibiting the oxygen diffusion into the semiconductor device and preventing the property of the element from deterioration thereof.

DISCLOSURE OF THE INVENTION

According to the present invention, a semiconductor device in which at least one capacitor using a ferroelectric substance or material is integrated on one and the same semiconductor substrate having formed thereat at least one active element, which is characterized in that

an oxygen-impermeable film of metal nitride is included as one of layers between the semiconductor substrate and the capacitor, and

a process for manufacturing the semiconductor device of the present invention, which is characterized in comprising the step of

carrying out the thermal treatment of the oxygen impermeable film of the metal nitride to turn or change it into an insulation film.

BRIEF DESCRIPTION OF THE DRAWINGS

Figs. 1(a) - 1(d) are main sectional views, respectively, showing a semiconductor device according to an embodiment of the present invention.

Fig. 2 is a main sectional view showing a semiconductor memory device according to the conventional technique.

BEST MODE FOR CARRYING OUT THE INVENTION

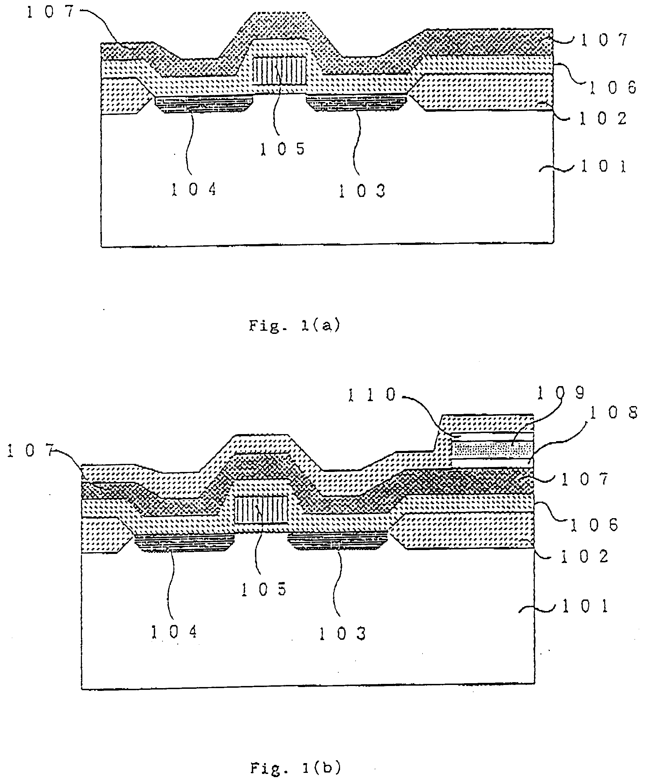

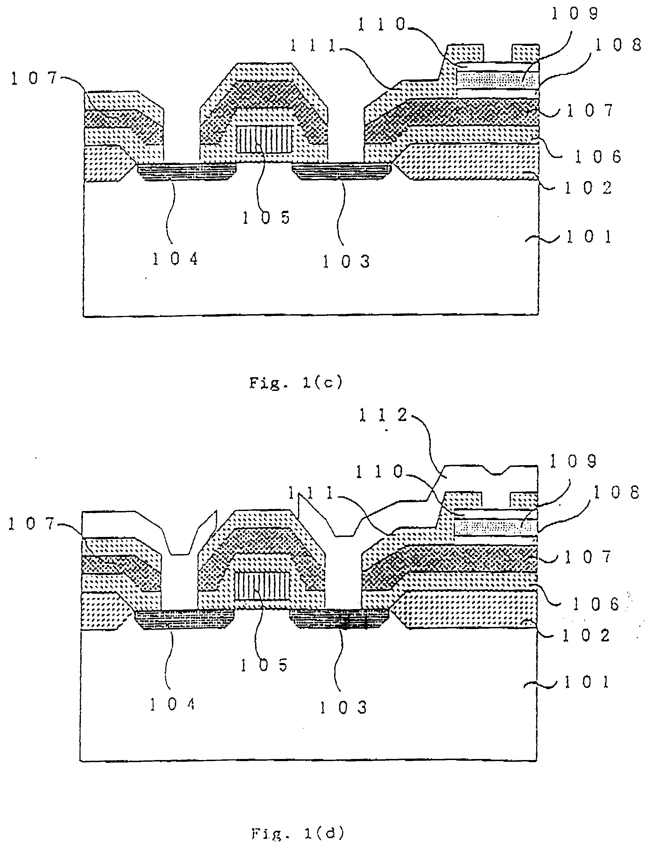

Figs. 1(a) - 1(d) are main sectional views, respectively, showing one embodiment of a semiconductor device of the present invention. A semiconductor device of the present invention will hereinafter be explained with reference to Fig. 1. Here, for the sake of brevity, the explanation will be given by an example, in which a Si substrate and an N-channel transistor are used.

(Fig. 1(a))

A reference numeral 101 designates a P-type Si substrate, which may, for example, be a wafer with a resistivity of 20 Ohm • cm. A reference numeral 102 designates an insulation film for isolation, which is formed of an oxide film to a thickness of 6000 Å by using the conventional LOCOS method. A reference numeral 103 designates an N-type diffusion layer intended to form a source and is formed by, for example, ion implantation of phosphorous with a condition of 80 KeV and $5 \times 10^{15}$ $cm^{-5}$. A reference numeral 104 designates an N-type diffusion layer intended to form a drain of the MOS transistor and formed simultaneously with 103. A reference numeral 105 shows a gate electrode which is formed, for example, of a phosphorus doped poly-silicon. A reference numeral 106 shows an interlayer insulation film which is formed, for example, of phosphorus glass to a thickness of 4000 Å by using CVD method.

A reference numeral 107 illustrates a conductive, oxygen-impermeable film according to the gist of the present invention. The film is formed, for example, of titanium nitride with a thickness of 1000 Å by using a sputtering method. Thereafter, by using the thermal or heat treatment in an oxygen atmosphere of 700 °C, the oxygen impermeable film 107 is turned into an insulation film.

A reference numeral 108 designates one (a lower electrode of the electrodes sandwiching the ferroelectric substance and formed to a thickness of 1000 A, for example, by the sputtering of platinum. A reference numeral 109 illustrates a ferroelectric film, which is formed of, for example, $PbTiO_3$ to a thickness of 2000 Å by the sputtering method and then sintered in the oxygen atmosphere at a temperature of 500°C. A reference numeral 110 shows the other one (an upper electrode) of the electrodes sandwiching the ferroelectric film, the electrode being formed the same way as the electrode 108. A reference numeral 111 shows the second interlayer insulation film which is formed of phosphorus glass to a thickness of 3000 Å by using, for example, the chemical vapor deposition method.

(Fig. 1(c))

Next, contact holes are formed by using the conventional photolithographic technique.

(Fig. 1(d))

A reference numeral 112 shows a wiring or interconnecting electrode, which is formed of, for example, aluminum to a thickness of 5000 Å by the sputtering method and formed in a shape of a predetermined pattern.

According to the above-mentioned process, a structure of the present embodiment can be obtained.

With such structure, the oxygen diffusion into the substrate will be inhibited during the thermal treatment in the oxygen atmosphere carried out after the forming of the oxygen impermeable film 107, and the step of the oxidization, and, thereby for preventing the deterioration of the properties or characteristics of the elements.

A structure having omitted the oxygen impermeable film 107 in such a structure as shown in Fig. 1(a) was subjected to the thermal treatment in an oxygen at a temperature of 5000°C when sintering $PbTiO_3$. Then, an off-leak current of about $10^{-7}$ A of the N type MOS transistor was attained at a drain voltage of 5 V. In contrast, when carrying out the similar thermal treatment to the structure of the present embodiment, the off-leak current of about $10^{-11}$ A was attained.

APPLICABILITY IN THE INDUSTRY

According to the present invention, an oxygen impermeable film of metal nitride is formed on a semiconductor substrate at which at least one active element is formed. Therefore, effects are obtained such that, during the thermal treatment in the oxidizing atmosphere at later steps, the oxygen diffusion into the semiconductor substrate is inhibited to thereby prevent the properties or characteristics of the element from deterioration thereof.

**Claims**

1. A semiconductor device in which at lease one capacitor having a ferroelectric substance is integrated on one and the same semiconductor substrate having formed thereat at least one active element, which is characterized in that layers between the semiconductor substrate and the capacitor include an oxygen impermeable film.

2. A semiconductor device as claimed in claim (1), which is characterized in that the layer of the oxygen impermeable film comprises as a main component metal nitride.

3. A process for manufacturing the semiconductor device as claimed in claim (1), which is characterized in comprising the step of oxidizing an oxygen impermeable film containing as a main component metal nitride.

Fig. 1(a)

Fig. 1(b)

Fig. 1(c)

Fig. 1(d)

Fig. 2

# INTERNATIONAL SEARCH REPORT

International Application No  PCT/JP91/01397

**I. CLASSIFICATION OF SUBJECT MATTER** (if several classification symbols apply, indicate all) [6]

According to International Patent Classification (IPC) or to both National Classification and IPC

Int. Cl$^5$  H01L27/115

**II. FIELDS SEARCHED**

| Minimum Documentation Searched [7] | |
|---|---|
| Classification System | Classification Symbols |
| IPC | H01L27/115, 29/792 |

| Documentation Searched other than Minimum Documentation to the Extent that such Documents are Included in the Fields Searched [8] |
|---|
| Jitsuyo Shinan Koho          1964 – 1990<br>Kokai Jitsuyo Shinan Koho    1973 – 1990 |

**III. DOCUMENTS CONSIDERED TO BE RELEVANT [9]**

| Category [*] | Citation of Document, [11] with indication, where appropriate, of the relevant passages [12] | Relevant to Claim No. [13] |
|---|---|---|
| Y | JP, A, 2-183569 (Seiko Epson Corp.), July 18, 1990 (18. 07. 90) | 1 |
| Y | JP, A, 62-188223 (Sony Corp.), August 17, 1987 (17. 08. 87) | 2 |
| A | JP, A, 1-253257 (Fuji Electric Co., Ltd.), October 9, 1989 (09. 10. 89) | 2 |

\* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| January 6, 1992 (06. 01. 92) | January 21, 1992 (21. 01. 92) |
| International Searching Authority | Signature of Authorized Officer |
| Japanese Patent Office | |